# EUROPÄISCHE PATENTSCHRIFT

(11) **EP 2 283 522 B1**
(45) Veröffentlichungstag und Bekanntmachung des Hinweises auf die Patenterteilung: **03.07.2013**
(21) Anmeldenummer: 09738208.9
(22) Anmeldetag: 30.04.2009
(51) Int. Cl.: H01L 31/048

(54) **PHOTOVOLTAIKMODULE ENTHALTEND WEICHMACHERHALTIGE ZWISCHENSCHICHT-FOLIEN MIT NIEDRIGER GLASÜBERGANGSTEMPERATUR**
PHOTOVOLTAIC MODULES CONTAINING PLASTICISED FILMS WITH A LOW GLASS TRANSITION TEMPERATURE AS INTERMEDIATE LAYERS
MODULES PHOTOVOLTAÏQUES CONTENANT DES FEUILLES PLASTIFIÉES FAISANT OFFICE DE COUCHE INTERMÉDIAIRE, À FAIBLE TEMPÉRATURE DE TRANSITION VITREUSE

(30) Priorität: 30.04.2008 DE 102008001501; 19.09.2008 DE 102008042218
(43) Veröffentlichungstag der Anmeldung: 16.02.2011
(73) Patentinhaber: Kuraray Europe GmbH, 65795 Hattersheim (DE)
(72) Erfinder: KARPINSKI, Andreas, 51519 Odenthal (DE); KELLER, Uwe, 53177 Bonn (DE); STENZEL, Holger, 53773 Hennef (DE); STEUER, Martin, 65835 Liederbach (DE)
(74) Vertreter: Kisters, Michael Marcus
(86) Internationale Anmeldenummer: PCT/EP2009/055244
(87) Internationale Veröffentlichungsnummer: WO 2009/133164

(56) Entgegenhaltungen:
- EP-A2- 1 617 487
- WO-A1-2005/108061
- WO-A2-2007/121079
- WO-A2-2009/047221
- WO-A2-2009/047222
- WO-A2-2009/071703
- DE-A1- 19 756 274

## Beschreibung

### Technisches Gebiet

Die Erfindung betrifft die Herstellung von Photovoltaikmodulen unter Verwendung von weichmacherhaltigen Folien auf Basis von Polyvinylacetal mit hohem spezifischen Widerstand und niedriger Glasübergangstemperatur.

### Stand der Technik

Photovoltaikmodule bestehen aus einer photosensitiven Halbleiterschicht, die zum Schutz gegen äußere Einflüsse mit einer transparenten Abdeckung versehen wird. Als photosensitive Halbleiterschicht können monokristalline Solarzellen oder polykristalline, dünne Halbleiterschichten auf einem Träger eingesetzt werden. Dünnschicht-Solarmodule bestehen aus einer photosensitiven Halbleiterschicht, die auf ein Substrat wie z.B. eine transparente Platte oder eine flexible Trägerfolie z.B. durch Aufdampfen, Gasphasenabscheidung, Sputtern oder Nassabscheidung aufgebracht ist.

Beide Systeme werden häufig zwischen eine Glasscheibe und eine rigide, hintere Abdeckplatte z.B. aus Glas oder Kunststoffen mit Hilfe eines transparenten Klebers laminiert.

Der transparente Kleber muss die photosensitive Halbleiterschicht und deren elektrische Verbindungsleitungen vollständig umschließen, UV-stabil und Feuchtigkeitsunempfindlich sein und nach dem Laminierprozess vollständig blasenfrei sein.

Als transparente Kleber werden häufig aushärtende Gießharze oder vernetzbare, auf Ethylenvinylacetat (EVA) basierende Systeme eingesetzt, so wie beispielsweise in DE 41 22 721 C1 oder DE 41 28 766 A1 offenbart. Diese Klebesysteme können im ungehärteten Zustand so niedrigviskos eingestellt werden, dass sie die Solarzelleneinheiten blasenfrei umschließen. Nach Zugabe eines Härters oder Vernetzungsmittels wird eine mechanisch widerstandfähige Klebeschicht erhalten. Nachteilig diesen Klebesystemen ist, dass beim Aushärteprozess häufig aggressive Substanzen wie Säuren freigesetzt werden, die die photosensitiven Halbleiterschichten, insbesondere Dünnschichtmodule, zerstören können. Zudem neigen einige Gießharze nach einigen Jahren zur Blasenbildung bzw. Delamination durch UV-Strahlung.

Eine Alternative zu aushärtenden Klebesystemen ist der Einsatz von weichmacherhaltigen Folien auf Basis von Polyvinylacetalen wie das aus der Verbundglasherstellung bekannte Polyvinylbutyral (PVB). Die Solarzelleneinheiten werden mit einer oder mehreren PVB-Folien bedeckt und diese unter erhöhtem Druck und erhöhter Temperatur mit den gewünschten Abdeckmaterialien zu einem Laminat verbunden.

Verfahren zur Herstellung von Solarmodulen mit Hilfe von PVB-Folien sind z. B. durch DE 40 26 165 C2, DE 42 278 60 A1, DE 29 237 70 C2, DE 35 38 986 C2 oder US 4,321,418 bekannt. Die Verwendung von PVB-Folien in Solarmodulen als Verbund-sicherheits-verglasungen ist z.B. in DE 20 302 045 U1, EP 1617487 A1, und DE 35 389 86 C2 offenbart. Diese Schriften enthalten aber keine Information über die mechanischen, chemischen und elektrischen Eigenschaften der verwendeten PVB-Folien.

Insbesondere die elektrischen Eigenschaften der Folien werden mit zunehmender Leistungsfähigkeit der photosensitiven Halbleiterschichten und der weltweiten Verbreitung von Solarmodulen immer wichtiger. Ladungsverluste oder gar Kurzschlüsse der Halbleiterschicht müssen auch unter extremen Witterungsbedingungen wie tropische Temperaturen, hohe Luftfeuchtigkeit oder starke UV-Strahlung über die gesamte Lebensdauer des Moduls vermieden werden. Photovoltaikmodule werden nach IEC 61215 einer Vielzahl von Tests unterzogen (Damp heat test, wet leakage current test) um Verlustströme der Module zu reduzieren.

Es ist bekannt, dass der spezifische Durchgangswiderstand von PVB-Folien mit steigendem Feuchtegehalt steil abfällt, was das Auftreten von Leckströmen in Photovoltaikmodulen stark begünstigt. Im Randbereich des Photovoltaikmoduls sind die Folien als Einkapselungsmaterial zur Umgebung offen und den Umweltbedingungen wie z.B. hohen Umgebungsfeuchten ausgesetzt. Hierdurch kann der Wassergehalt der Folien im Randbereich stark zunehmen und Werte bis zur Gleichgewichtsfeuchte (ca. 3 Gew. %) annehmen. Der erhöhte Wassergehalt im Randbereich der Folie reduziert deren elektrischen Widerstand in diesem Bereich stark. Der Wassergehalt nimmt zwar zur Folienmitte wieder ab, aber zur Vermeidung von Leckströmen können die photosensitiven Halbleiterschichten daher nicht bis in den Randbereich der Folie bzw. des Moduls verlegt werden. Dies reduziert die Flächenbelegung und damit die Stromausbeute des Moduls.

Klebefolien für Photovoltaikmodule müssen daher einen möglichst hohen spezifischen Durchgangswiderstand aufweisen. Hierzu beschreibt DE 102007000816.5 WO 2009/04722 Klebefolien aus Polyvinylacetalen mit erhöhtem spezifischen Durchgangswiderstand und erniedrigtem Weichmachergehalt, die Glasübergangstemperaturen Tg von mehr als 20°C aufweisen.

Photovoltaikmodule mit Klebeschichten aus weichmacherhaltigen PVB-Folien mit unterschiedlichen Zusammensetzungen und Additiven sind z.b. aus W02009/071703, WO2009/047222 oder EP 1617487 bekannt.

Nachteilig an derartigen Systemen sind die erhöhten Produktkosten, da der Weichmacher in der Regel preiswerter als das Polyvinylacetal ist. Weiterhin verschlechtert sich durch die Reduktion des Weichmachergehaltes die Fließfähigkeit der Folie, wodurch Probleme bei der Laminierung der Photovoltaikmodule resultieren können.

### Technische Aufgabe

Aufgabe der vorliegenden Erfindung war es daher, andere weichmacherhaltige Folien auf Basis von Polyvinylacetal mit hohem spezifischem Durchgangswiderstand zur Herstellung von Photovoltaikmodulen bereit zu stellen.

### Darstellung der Erfindung

Gegenstand der vorliegenden Erfindung sind daher Photovoltaikmodule, umfassend ein Laminat aus
a) einer transparenten Frontabdeckung
b) einer oder mehreren photosensitiven Halbleiterschichten
c) mindestens einer weichmacherhaltigen, auf Polyvinylacetal basierenden Folie, die in einem Umgebungsklima von 85 % r.F./23°C einen spezifischen elektrischen Durchgangswiderstand von mehr als 1 E12 Ohm*cm besitzt und
d) einer rückwärtigen Abdeckung, wobei die weichmacherhaltige, auf Polyvinylacetal basierende Folie c) eine Glasübergangstemperatur Tg von weniger als 20 °C und einen Alkalititer über 5 aufweist und das das Polyvinylacetal einen Polyvinylalkoholanteil von weniger als 18 Gew.% aufweist.

Bevorzugt weisen die erfindungsgemäß eingesetzten Folien bei einer Umgebungsfeuchte von 85% rF bei 23°C einen spezifischen Widerstand von mindestens 5E+12 ohm*cm, besonders bevorzugt von mindestens 1E+13ohm*cm, insbesondere von mindestens 5E+13, oder von mindestens 1E+14 ohm*cm auf.

Die Glasübergangstemperatur Tg der erfindungsgemäß eingesetzten Folie kann durch den Restacetatgehalt, den Polyvinylalkoholgehalt, den Vernetzungsgrad und die Kettenlänge des Polyvinylacetals sowie die Art und den Anteil des Weichmachers beeinflusst werden.

Die im Folgenden aufgeführten Maßnahmen zur Veränderung dieser Eigenschaften kann jeweils einzeln aber auch in Kombination miteinander durchgeführt werden.

Die Glasübergangstemperatur Tg der erfindungsgemäß eingesetzten Folien beträgt bevorzugt maximal 19,5°C, besonders bevorzugt maximal 18°C, insbesondere maximal 16 °C oder maximal 15 °C. Als Untergrenze für die Glasübergangstemperatur Tg kann 0°C angegeben werden.

Zur Herstellung von Polyvinylacetal wird Polyvinylalkohol in Wasser gelöst und mit einem Aldehyd wie Butyraldehyd unter Zusatz eines Säurekatalysators acetalisiert. Das ausgefallene Polyvinylacetals wird abgetrennt, neutral gewaschen, ggf. in einem alkalisch eingestellten wässrigen Medium suspendiert, danach erneut neutral gewaschen und getrocknet.

Die zur Acetalisierung eingesetzte Säure muss nach erfolgter Reaktion wieder neutralisiert werden. Wird hier ein Überschuss an Base (z.b. NaOH, KOH oder Mg(OH)₂) eingesetzt, so erhöht sich der Alkalititer und es kann ganz oder teilweise auf die Zugabe der basischen Substanz verzichtet werden.

Der Polyvinylalkoholgehalt des Polyvinylacetals kann durch die Menge des bei der Acetalisierung eingesetzten Aldehyds eingestellt werden.

Es ist auch möglich, die Acetalisierung mit anderen oder mehreren Aldehyden mit 2-10 Kohlenstoffatomen (z.B. Valeraldehyd) durchzuführen.

Die auf weichmacherhaltigem Polyvinylacetal basierenden Folien enthalten bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98 Mol% hydrolysiert und enthalten 1 bis 10 Gew. auf Ethylen basierende Einheiten (z.B. Typ "Exceval" der Kuraray Europe GmbH).

Als Polyvinylalkohol können im Rahmen der vorliegenden Erfindung weiterhin auch hydrolysierte Copolymere aus Vinylacetat und mindestens einem weiteren ethylenisch ungesättigten Monomer eingesetzt werden.

Die Polyvinylalkohole können im Rahmen der vorliegenden Erfindung rein oder als Mischung von Polyvinylalkoholen mit unterschiedlichem Polymerisationsgrad oder Hydrolysegrad eingesetzt werden.

Polyvinylacetale enthalten neben den Acetaleinheiten noch aus Vinylacetat und Vinylalkohol resultierende Einheiten. Die erfindungsgemäß verwendeten Polyvinylacetale weisen bevorzugt einen Polyvinylalkoholanteil von weniger als 17 Gew. %, weniger als 16 Gew.% oder 15 Gew.% und insbesondere weniger als 14 Gew.% auf. Ein Polyvinylalkoholanteil von 12 Gew.% sollte nicht unterschritten werden.

Der Polyvinylacetatgehalt des erfindungsgemäß eingesetzten Polyvinylacetals liegt bevorzugt unter 3 Gew.%, besonders bevorzugt unter 2 Gew.%, ganz besonders bevorzugt unter 1 Gew.%.

Aus dem Polyvinylalkoholanteil und dem Restacetatgehalt kann der Acetalisierungsgrad rechnerisch ermittelt werden.

Bevorzugt weisen die Folien einen Weichmachergehalt von maximal 40 Gew.%, 35 Gew.%, 32 Gew.%, 30 Gew.%, 28 Gew.%, 26 Gew.%, 24 Gew.% oder 22 Gew.% auf, wobei ein Weichmachergehalt von 15 Gew.% aus Gründen der Verarbeitbarkeit der Folie nicht unterschritten werden sollte (jeweils bezogen auf die gesamte Folienformulierung). Erfindungsgemäße Folien bzw. Photovoltaikmodule können einen oder mehrere Weichmacher enthalten.

Geeignete Weichmacher für die erfindungsgemäß eingesetzten Folien sind eine oder mehrere Verbindungen ausgewählt aus den folgenden Gruppen:
- Ester von mehrwertigen aliphatischen oder aromatischen Säuren, z.B. Dialkyladipate wie Dihexyladipat, Dioctyladipat, Hexylcyclohexyladipat, Mischungen aus Heptyl- und Nonyl-adipaten, Diisononyladipat, Heptylnonyl-adipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Phthalsäure wie Butylbenzylphthalat oder Bis-2-butoxyethylphthalat
- Ester oder Ether von mehrwertigen aliphatischen oder aromatischen Alkoholen oder Oligoetherglykolen mit einem oder mehreren unverzweigen oder verzweigten aliphatischen oder aromatischen Substituenten, wie z.B. Estern von Di-, Tri- oder Tetraglykolen mit linearen oder verzweigten ali-phatischen oder cycloaliphatischen Carbonsäuren; Als Beispiele für letztere Gruppe können dienen Diethylenglykol-bis-(2-ethyl-hexanoat), Triethylenglykol-bis-(2-ethyl-hexanoat), Tri-ethylen-glykol-bis-(2-ethylbu-ta-no-at), Tetra-ethylen-glykol-bis-n-heptanoat, Triethylengly-kol-bis-n-heptanoat, Triethylenglykol-bis-n-hexanoat, Tetraethylen-glykol-dimethyl-ether und/oder Dipropylenglykolbenzoat
- Phosphate mit aliphatischen oder aromatischen Esteralkoholen wie z.B. Tris(2-ethylhexyl)phosphat (TOF), Triethylphosphat, Diphenyl-2-ethylhexylphosphat, und/oder Trikresylphosphat
- Ester der Zitronensäure, Bernsteinsäure und/oder Fumarsäure

Besonders geeignet als Weichmacher für die erfindungsgemäß eingesetzten Folien sind eine oder mehrere Verbindungen ausgewählt aus der folgende Gruppe Di-2-ethylhexylsebacat (DOS), Di-2-ethylhexyladipat (DOA), Dihexyladipat (DHA), Dibutylsebacat (DBS), Triethylenglykol-bis-n-heptanoat (3G7), Tetraethylenglykol-bis-n-heptanoat (4G7), Triethylenglykol-bis-2-ethylhexanoat (3GO bzw. 3G8) Tetraethylenglykol-bis-n-2-ethylhexanoat (4GO bzw. 4G8) Di-2-butoxy-ethyl-adipat (DBEA), Di-2-butoxyethoxyethyladipat (DBEEA) Di-2-butoxyethylsebacat (DBES), Di-2-ethylhexylphthalat (DOP), Di-isononylphthalat (DINP) Triethylenglykolbis-isononanoat, Triethylenglykol-bis-2-propylhexanoat, Tris(2-ethylhexyl)phosphat (TOF), 1,2 Cyclohexandicarbonsäurediisononylester (DINCH) und Dipropylenglykolbenzoat.

Ganz besonders geeignet als Weichmacher für die erfindungsgemäß eingesetzten Folien sind Weichmacher, deren Polarität, ausgedrückt durch die Formel 100 x O/(C+H) kleiner/gleich 9,4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

**Tabelle 1**

| Name | Polaritätswert |
|---|---|
| Di-2-ethylhexylsebacat (DOS) | 5,3 |
| Diisononylcyclohexandicarbonsäureester (DINCH) | 5,4 |
| Di-2-ethylhexyladipat (DOA) | 6,3 |
| Di-2-ethylhexylphthalat (DOP) | 6,5 |
| Triethylenglykol-bis-2-propylhexanoat | 8,6 |
| Triethylenglykol-bis-i-nonanoat | 8,6 |
| Di-2-butoxyethylsebacat (DBES) | 9,4 |
| Triethylenglykol-bis-2-ethylhexanoat (3G8) | 9,4 |

Weiterhin kann die möglicherweise vom Wassergehalt der Folie abhängende lonenbeweglichkeit und damit der spezifische Widerstand durch den Zusatz von SiO₂, insbesondere pyrogener Kieselsäure beeinflusst werden. Bevorzugt enthalten die weichmacherhaltigen, auf Polyvinylacetal basierenden Folien 0.001 bis 15 Gew.%, bevorzugt 2 bis 5 Gew.% SiO₂.

Die Vermeidung von Säurespuren bei der Herstellung des Folienmaterials ist eine Möglichkeit, die Korrosionsneigung der erfindungsgemäß eingesetzten Folien gegenüber photosensitiven Halbleiterschichten zu verringern. Folien dieser Art werden in der Regel durch Extrusion unter erhöhten Temperaturen hergestellt, wodurch eine thermische Zersetzung des polymeren Materials bzw. des Weichmachers auftreten kann. Weiterhin kann durch eindiffundiertes Wasser eine Spaltung der Restacetatgruppen des Polyvinylalkohols auftreten, wodurch Essigsäure freigesetzt wird. In beiden Fällen resultieren Säurespuren, die die photosensitiven Halbleiterschichten angreifen können.

Bevorzugt weisen die erfindungsgemäß eingesetzten Folien daher eine gewisse Basizität, ausgedrückt als Alkali-Titer auf, der über 10, bevorzugt über 15 und insbesondere über 20, 30 oder 40 liegen sollte. Ein maximaler Alkali-Titer von 100 sollte nicht überschritten werden.

Der Alkali-Titer wird, wie im folgenden beschrieben, durch Rücktitration der Folie bestimmt und kann durch Zugabe von basischen Substanzen, wie z.B. Metallsalze von organischen Carbonsäuren mit 1 bis 15 Kohlenstoffatomen, insbesondere Alkali- oder Erdalkalisalze wie Magnesium- oder Kaliumacetat eingestellt werden. Die basische Verbindung wird üblicherweise in einer Konzentration von 0,005 bis 2 Gew.% insbesondere 0,05 bis 1 Gew.%, bezogen auf die gesamte Mischung eingesetzt.

Weiterhin können die erfindungsgemäßen Folien zusätzlich auch übliche Additive, wie zum Beispiel Oxidationsstabilisatoren, UV-Stabilisatoren, Farbstoffe, Pigmente sowie Antihaftmittel enthalten.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Die Herstellung der Photovoltaikmodule erfolgt durch Laminierung der transparenten Frontabdeckung a), den photosensitiven Halbleiterschichten b) und der rückwärtigen Abdeckung d) mittels mindestens einer weichmacherhaltigen, auf Polyvinylacetal basierenden Folie c) unter Verschmelzung der Folien, so dass ein blasen- und schlierenfreier Einschluss der photosensitiven Halbleiterschicht erhalten wird.

In dieser Variante der erfindungsgemäßen Photovoltaikmodule werden die photosensitiven Halbleiterschichten zwischen zwei Folien c) eingebettet und so mit den Abdeckungen a) und d) verklebt.

Die Dicke der auf weichmacherhaltigem Polyvinylacetal basierenden Folien liegt üblicherweise bei 0.38, 0.51, 0.76, 1.14, 1.52 oder 2.28 mm.

Insbesondere bei Dünnschicht-Solarmodulen ist die photosensitive Halbleiterschicht direkt auf einen Träger aufgebracht (z.B. durch Aufdampfen, Gasphasenabscheidung, Sputtern oder Nassabscheidung). Eine Einkapselung der photosensitive Halbleiterschicht ist hier nicht möglich.

In einer Variante der erfindungsgemäßen Photovoltaikmodule werden die photosensitiven Halbleiterschichten auf die Abdeckung d) aufgebracht (z.B. durch Aufdampfen, Gasphasenabscheidung, Sputtern oder Nassabscheidung) und durch mindestens eine Folie c) mit der transparenten Frontabdeckung a) verklebt.

In einer anderen Variante werden die photosensitiven Halbleiterschichten auf die transparente Frontabdeckung a) aufgebracht und durch mindestens eine Folie c) mit der rückwärtigen Abdeckung d) verklebt.

In der Regel wird bei Dünnschicht-Modulen die photosensitive Halbleiterschicht ganzflächig auf den Träger aufgebracht d.h. bis zum Rand des Trägers. Anschließend wird am Rand ein Teil der photosensitiven Halbleiterschicht wieder entfernt, sodass zu Isolationszwecken ein Halbleiter-freier Randbereich übrig bleibt (sog. Randentschichtung). Durch die hohen Widerstandswerte der erfindungsgemäß eingesetzten Folie kann dieser Randbereich mit bevorzugt unter 3 cm, ganz besonders unter 2 cm und insbesondere unter 1 cm sehr schmal ausfallen.

Erfindungsgemäß eingesetzte Folien füllen während des Laminierprozesses die an den photosensitiven Halbleiterschichten bzw. deren elektrischen Verbindungen vorhandenen Hohlräume aus.

Die transparente Frontabdeckung besteht in der Regel aus Glas oder PMMA. Die rückwärtige Abdeckung des erfindungsgemäßen Photovoltaikmoduls kann aus Glas, Kunststoff oder Metall oder deren Verbünden bestehen, wobei mindestens einer der Träger transparent sein kann. Es ist ebenfalls möglich, einen oder beide Abdeckungen als Verbundverglasung (d. h. als Laminat aus mindestens zwei Glasscheiben und mindestens einer PVB-Folie) oder als Isolier-verglasung mit einem Gaszwischenraum auszuführen. Selbstverständlich ist auch die Kombination dieser Maßnahmen möglich.

Die in den Modulen eingesetzten photosensitiven Halbleiterschichten müssen keine besonderen Eigenschaften besitzen. Es können mono-, polykristalline oder amorphe Systeme eingesetzt werden.

Zur Laminierung der so erhaltenen Schichtkörpers können die dem Fachmann geläufigen Verfahren mit und ohne vorhergehende Herstellung eines Vorverbundes eingesetzt werden.

So genannte Autoklavenprozesse werden bei einem erhöhten Druck von ca. 10 bis 15 bar und Temperaturen von 130 bis 145 °C über ca. 2 Stunden durchgeführt. Vakuumsack- oder Vakuumring-verfahren z.B. gemäß EP 1 235 683 B1 arbeiten bei ca. 200 mbar und 130 bis 145 °C

Vorzugsweise werden zur Herstellung der erfindungsgemäßen Photovoltaikmodule Vakuumlaminatoren eingesetzt. Diese bestehen aus einer beheizbaren und evakuierbaren Kammer, in denen Verbund-verglasungen innerhalb von 30 - 60 Minuten laminiert werden können. Verminderte Drücke von 0,01 bis 300 mbar und Temperaturen von 100 bis 200 °C, insbesondere 130 - 160 °C haben sich in der Praxis bewährt.

Alternativ kann ein so oben beschrieben zusammengelegter Schichtkörper zwischen mindestens einem Walzenpaar bei einer Temperatur von 60 bis 150 °C zu einem erfindungsgemäßen Modul verpresst werden. Anlagen dieser Art sind zur Herstellung von Verbundverglasungen bekannt und verfügen normalerweise über mindestens einen Heiztunnel vor bzw. nach dem ersten Presswerk bei Anlagen mit zwei Presswerken.

### Gewerbliche Anwendbarkeit

Weiterhin ist Gegenstand der Erfindung die Verwendung von weichmacherhaltigen, auf Polyvinylacetal basierenden Folien, die in einem Umgebungsklima von 85 % r.F./23°C einen spezifischen elektrischen Durchgangswiderstand von mehr als 1 E12 Ohm*cm und eine Glasübergangstemperatur Tg von weniger als 20 °C, einem Alkalititer über 5 und Polyvinylacetal mit einem Polyvinylalkohol anteil von weniger als 18 Gew% aufweisen, bzw. mit den genannten bevorzugten Ausführungsformen zur Herstellung von Photovoltaikmodulen.

Erfindungsgemäße Photovoltaikmodule können als Fassadenbauteil, Dachflächen, Wintergartenabdeckung, Schallschutzwand, Balkon- oder Brüstungselement oder als Bestandteil von Fensterflächen verwendet werden.

### Messmethoden:

Die Messung des spezifischen Durchgangswiderstandes der Folie erfolgt gemäß DIN IEC 60093 bei definierter Temperatur und Umgebungsfeuchte (23 °C und 85% rLF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmessgerät ISO-Digi 5kV von der Firma Amprobe verwendet. Die Prüfspannung betrug 2,5kV, die Wartezeit nach Anlegen der Prüfspannung bis zur Messwerterfassung 60 sek. Damit ein ausreichender Kontakt zwischen den flachen Platten der Messelektrode und der Folie gewährleistet ist, sollte deren Oberflächenrauhikgkeit R_{z} bei Messung nach DIN EN ISO 4287 nicht größer als 10 mm sein, d.h. gegebenenfalls muss die Originaloberfläche der PVB-Folie vor der Widerstandsmessung durch thermisches Umprägen geglättet werden.

Der Polyvinylalkohol- und Polyvinylalkoholacetatgehalt der Polyvinylacetale wurde gemäß ASTM D 1396-92 bestimmt. Die Analyse des Metallionengehaltes erfolgte durch Atomabsorptionsspekroskopie (AAS).

Der Wasser- bzw. Feuchtegehalt der Folien wird mit der Karl-Fischer-Methode bestimmt. Diese Methode kann sowohl an der unlaminierten Folie als auch an einem laminierten Photovoltaikmodul in Abhängigkeit vom Abstand zum Rand der Folie durchgeführt werden.

Alkali-Titer

3 bis 4 gr. des weichmacherhaltigen Polyvinylacetal-Films wird in 100 ml einer Mischung von Ethanol/THF (80:20) in einem Magnetrührer über Nacht gelöst. Hierzu werden 10 ml einer verdünnten Salzsäure (c=0,01 mol/Liter) gegeben und anschließend potentiometrisch mit einer Lösung von Tetrabutylammoniumhydroxid (TBAH) in 2-Propanol (c=0,01 mol/Liter) mit einem Titroprozessor gegen eine Leerprobe potentiometrisch titriert. Der Alkali-Titer berechnet sich wie folgt:

Alkali-Titer = ml HCl pro 100 gr einer Probe = (Verbrauch TBAH Leerprobe - TBAH Probe x 100 durch Gewicht der Probe in gr.)

Glasübergangstemperatur Tg

Die Bestimmung der Glasübergangstemperatur der Folie erfolgt mittels Dynamischer Differenzkalorimetrie (DSC) gemäß DIN 53765 unter Verwendung einer Heizrate von 10K/min im Temperaturintervall -50 °C - 150°C. Es wird eine erste Heizrampe, gefolgt von einer Kühlrampe, gefolgt von einer zweiten Heizrampe gefahren. Die Lage der Glasübergangstemperatur wird an der der zweiten Heizrampe zugehörigen Messkurve nach DIN 51007 ermittelt. Der DIN-Mittelpunkt (Tg DIN) ist definiert als Schnittpunkt einer Horizontalen auf halber Stufenhöhe mit der Messkurve. Die Stufenhöhe ist durch den vertikalen Abstand der beiden Schnittpunkte der Mitteltangente mit den Basislinien der Messkurve vor und nach Glasumwandlung definiert.

Die Viskositäten wurden nach DIN53015 als 5 bzw. 10% Lösung in Ethanol (mit 5 % Wasser) bei 20°C gemessen.

### Beispiele:

### Vergleichsbeispiel 1

100 Gewichtsteile des Polyvinylalkohols Mowiol 28-99 (Handelsprodukt von Kuraray Europe GmbH) wurden in Wasser gelöst. Es wurden 56,7 Gewichtsteile n-Butyraldehyd und 75 Gewichtsteile 20 %ige Salzsäure zugegeben. Das ausgefallene Polyvinylbutyral (PVB) wurde abgetrennt, mit Wasser neutral gewaschen und getrocknet. Es wurde ein PVB mit einem Polyvinylakoholgehalt von 20,2 Gew.% und einem Polyvinylacetatgehalt von 1,5 Gew.% erhalten.

290 g des so erhaltenen PVB, 100 g Weichmacher 3G8 und 10 g Weichmacher DBEA wurden in einem Labormischer (Hersteller: Brabender, Modell 826801) gemischt. Die erhaltene Mischung wurde zu Flachfolie mit einer Dicke von 0,8 mm extrudiert. Die Extrusion erfolgte auf einem Doppelschneckenextruder mit gegenlaufenden Schnecken (Hersteller: Haake, System Rhecord 90), ausgerüstet mit Schmelzepumpe und Breitschlitzdüse. Die Zylindertemperatur des Extruders betrug 220 °C, die Düsentemperatur betrug 150°C.

### Vergleichsbeispiel 2

Bei der Extrusion wurden 304 g PVB gemäß Vergleichsbeispiel 1 und 96 g Weichmacher DOA eingesetzt. Das sonstige Vorgehen erfolgte gemäß Vergleichsbeispiel 1.

### Beispiel 1

Die PVB-Herstellung erfolgte gemäß Vergleichsbeispiel 1, wobei 65,1 Gewichtsteile n-Butyraldehyd eingesetzt wurden. Es wurde ein PVB mit einem Polyvinylakoholgehalt von 15,4 Gew.% und einem Polyvinylacetatgehalt von 1,5 Gew.% erhalten.

Die Extrusion erfolgte gemäß Vergleichsbeispiel 2.

### Beispiel 2

Die PVB-Herstellung erfolgte gemäß Vergleichsbeispiel 1, wobei 67,8 Gewichtsteile n-Butyraldehyd eingesetzt wurden. Es wurde ein PVB mit einem Polyvinylakoholgehalt von 14,1 Gew.% und einem Polyvinylacetatgehalt von 1,8 Gew.% erhalten.

Die Extrusion erfolgte gemäß Vergleichsbeispiel 2.

### Beispiel 3

Die Extrusion erfolgte gemäß Vergleichsbeispiel 2, wobei 304 g PVB gemäß Beispiel 2 und 96 g Weichmacher 3G8 eingesetzt wurden.

### Beispiel 4

Die PVB-Herstellung erfolgte gemäß Vergleichsbeispiel 1, wobei 69,0 Gewichtsteile n-Butyraldehyd eingesetzt wurden. Es wurde ein PVB mit einem Polyvinylakoholgehalt von 15,2 Gew.% und einem Polyvinylacetatgehalt von 1,5 Gew.% erhalten.

Die Extrusion erfolgte gemäß Vergleichsbeispiel 1, wobei 290 g PVB gemäß Beispiel 4 und 110 g Weichmacher DOA eingesetzt wurden.

### Beispiel 5

Die PVB-Herstellung erfolgte gemäß Vergleichsbeispiel 1, wobei 66,3 Gewichtsteile n-Butyraldehyd eingesetzt wurden. Es wurde ein PVB mit einem Polyvinylakoholgehalt von 16,1 Gew.% und einem Polyvinylacetatgehalt von 1,4 Gew.% erhalten.

Die Extrusion erfolgte gemäß Vergleichsbeispiel 1, wobei 290 g PVB gemäß Beispiel 5 und 110 g Weichmacher DOA eingesetzt wurden.

### Beispiel 6

Die PVB-Herstellung erfolgte gemäß Vergleichsbeispiel 1, wobei 63,9 Gewichtsteile n-Butyraldehyd eingesetzt wurden. Es wurde ein PVB mit einem Polyvinylakoholgehalt von 17,2 Gew.% und einem Polyvinylacetatgehalt von 1,6 Gew.% erhalten.

Die Extrusion erfolgte gemäß Vergleichsbeispiel 1, wobei 290 g PVB gemäß Beispiel 6 und 110 g Weichmacher DOA eingesetzt wurden.

Es wurden Folien der in Tabelle 2 und 3 aufgeführten Zusammensetzungen hergestellt und auf ihre Glasübergangstemperatur Tg, den Wassergehalt und den spezifischen Durchgangswiderstand untersucht.

Es bedeuten
DBEEA: Di-2-butoxyethoxyethyladipat
3G8: Triethylenglykol-bis-2-ethylhexanoat
DOA: Dioctyladipat

Der Wassergehalt und der spezifische elektrische Durchgangswiderstand (Ohm*cm) werden jeweils nach Konditionierung bei 85% r.F./23°C, die Glasübergangstemperatur Tg (°C) nach DIN (DSC) bestimmt. Alle Werte sind in Gew% bezogen auf die Folienmischung angegeben.

### Ergebnis

Es zeigt sich, dass Folien aus Standard-PVB mit mittlerem Weichmacheranteil (VB1) einen für Photovoltaikanwendungen zu niedrigen Durchgangswiderstand aufweisen. Folien mit erniedrigtem Weichmacheranteil aus Standard-PVB (VB2) besitzen zwar einen hohen Durchgangswiderstand aber eine hohe Glasübergangstemperatur Tg von über 20 °C. Dies erschwert die Verarbeitung der Folie im Laminierverfahren d.h. das Einkapseln oder Umfließen der photosensitiven Halbleiterschichten oder deren elektrischen Anschlüsse.

Eine Verringerung des PVOH-Gehaltes des erfindungsgemäß eingesetzten Polyvinylbutyrals bewirkt eine deutliche Absenkung der Glasübergangstemperatur unter 20 °C bei ausreichend hohem spezifischem Durchgangswiderstand.

Die erfindungsgemäßen Beispiele zeigen, dass durch die erfindungsgemäß eingesetzten Folien eine Kombination von hohem spezifischen Durchgangswiderstand und niedriger Glasübergangstemperatur erreicht werden kann. Folien dieser Art sind für Photovoltaikanwendungen besonders geeignet.

**Tabelle 2**

| | **VB 1** | **VB 2** | **Bsp. 1** | **Bsp. 2** |
|---|---|---|---|---|
| **Zusammensetzung Folie** | | | | |
| PVB | 72,5 | 76 | 76 | 76 |
| Weichmacher 3G8 | 25 | | - | - |
| Weichmacher DBEA | 2,5 | - | - | - |
| Weichmacher DOA | - | 24 | 24 | 24 |
| Weichmachergehalt in Summe | 27,5 | 24 | 24 | 24 |
| | | | | |

| **Charakterisierung** | | | | |
|---|---|---|---|---|
| PVOH-Gehalt PVB | 20,2 | 20,2 | 15,4 | 14,1 |
| Wassergehalt Folie | 2,48 | 1,96 | 1,84 | 1,54 |
| Durchgangswiderstand | 1,5E+11 | 3,1E+12 | 7,9E+12 | 1,5E+13 |
| Tg (DSC) | 18,6 | 25,6 | 18,3 | 16,9 |

**Tabelle 3**

| | **Bsp. 3** | **Bsp.4** | **Bsp. 5** | **Bsp. 6** |
|---|---|---|---|---|
| **Zusammensetzung Folie** | | | | |
| PVB | 76 | 72,5 | 72,5 | 72,5 |
| Weichmacher 3G8 | 24 | - | - | - |
| Weichmacher DBEA | - | - | - | - |
| Weichmacher DOA | - | 27,5 | 27,5 | 27,5 |
| Weichmachergehalt in Summe | 24 | 27,5 | 27,5 | 27,5 |
| | | | | |

| **Charakterisierung** | | | | |
|---|---|---|---|---|
| PVOH-Gehalt PVB | 14,1 | 15,2 | 16,1 | 17,2 |
| Wassergehalt Folie | 1,69 | 1,7 | 1,7 | 1,9 |
| Durchgangswiderstand | 1,5E+12 | 2,4E+12 | 1,4E+12 | 1,4E+12 |
| Tg (DSC) | 15,5 | 14,3 | 15,2 | 17,1 |

## Patentansprüche

1. Photovoltaikmodul, umfassend ein Laminat aus
a) einer transparenten Frontabdeckung
b) einer oder mehreren photosensitiven Halbleiterschichten
c) mindestens einer weichmacherhaltigen, auf Polyvinylacetal basierenden Folie, die in einem Umgebungsklima von 85 % r.F./23°C einen spezifischen elektrischen Durchgangswiderstand von mehr als 1 E12 Ohm*cm besitzt und
d) einer rückwärtigen Abdeckung
**dadurch gekennzeichnet, dass** die weichmacherhaltige, auf Polyvinylacetal basierende Folie c) eine Glasübergangstemperatur Tg von weniger als 20 °C und einen Alkalititer über 5 aufweist und das das Polyvinylacetal einen Polyvinylalkoholanteil von weniger als 18 Gew.% aufweist.

2. Photovoltaikmodul nach Anspruch 1 **dadurch gekennzeichnet, dass** die weichmacherhaltigen, auf Polyvinylacetal basierenden Folien c) einen Weichmachergehalt von maximal 40 Gew.% aufweisen.

3. Photovoltaikmodul nach einem der Ansprüche 1 bis 2 **dadurch gekennzeichnet, dass** das Polyvinylacetal einen Polyvinylacetatgehalt von weniger als 3 Gew.% aufweist.

4. Photovoltaikmodul nach einem der Ansprüche 1 bis 3 **dadurch gekennzeichnet, dass** die weichmacherhaltigen auf Polyvinylacetal basierenden Folien c) ein Metallsalz einer Carbonsäure mit 1 bis 15 Kohlenstoffatomen als basische Verbindung enthalten.

5. Photovoltaikmodul nach einem der Ansprüche 1 bis 4 **dadurch gekennzeichnet, dass** die weichmacherhaltige, auf Polyvinylacetal basierende Folie 0.001 bis 5 Gew.% SiO₂ enthält.

6. Photovoltaikmodul nach einem der Ansprüche 1 bis 5 **dadurch gekennzeichnet, dass** die photosensitiven Halbleiterschichten auf die Abdeckung d) aufgebracht und durch mindestens eine weichmacherhaltige, auf Polyvinylacetal basierende Folie c) mit der transparenten Frontabdeckung a) verklebt werden.

7. Photovoltaikmodul nach einem der Ansprüche 1 bis 5 **dadurch gekennzeichnet, dass** die photosensitiven Halbleiterschichten auf die transparente Frontabdeckung a) aufgebracht und durch mindestens eine weichmacherhaltige, auf Polyvinylacetal basierende Folie c) mit der der rückwärtigen Abdeckung d) verklebt werden.

8. Photovoltaikmodul nach einem der Ansprüche 1 bis 5 **dadurch gekennzeichnet, dass** eine oder mehrere photosensitive Halbleiterschichten b) zwischen zwei Folien c) eingebettet und mit den Abdeckungen a) und d) verklebt werden.

9. Verwendung von weichmacherhaltigen, auf Polyvinylacetal basierenden Folien, die in einem Umgebungsklima von 85 % r.F./23°C einen spezifischen elektrischen Durchgangswiderstand von mehr als 1E12 Ohm*cm und eine Glasübergangstemperatur Tg von weniger als 20 °C und einen Alkalititer über 5 aufweisen und Polyvinylacetal mit einem Polyvinylalkoholanteil von weniger als 18 Gew.% aufweisen, zur Herstellung von Photovoltaikmodulen.

10. Verwendung von Photovoltaikmodulen gemäß einem der Ansprüche 1 bis 8 als Fassadenbauteil, Dachflächen, Wintergartenabdeckung, Schallschutzwand, Balkon- oder Brüstungselement oder als Bestandteil von Fensterflächen

## Claims

1. A photovoltaic module, comprising a laminate formed from
a) a transparent front cover,
b) one or more photosensitive semiconductor layers,
c) at least one plasticised film based on polyvinyl acetal, which, in an ambient climate of 85 % RH/23 °C, has an electrical volume resistivity of more than 1E12 ohm*cm, and
d) a rear cover,
**characterised in that** the plasticised film based on polyvinyl acetal c) has a glass transition temperature Tg of less than 20 °C and an alkali titre above 5, and **in that** the polyvinyl acetal has a polyvinyl alcohol proportion of less then 18 % by weight.

2. The photovoltaic module according to Claim 1, **characterised in that** the plasticised films based on polyvinyl acetal c) have a plasticiser content of at most 40 % by weight.

3. The photovoltaic module according to one of Claims 1 to 2, **characterised in that** the polyvinyl acetal has a polyvinyl acetal content of less than 3 % by weight.

4. The photovoltaic module according to one of Claims 1 to 3, **characterised in that** the plasticised films based on polyvinyl acetal c) contain a metal salt of a carboxylic acid comprising 1 to 15 carbon atoms as an alkaline compound.

5. The photovoltaic module according to one of Claims 1 to 4, **characterised in that** the plasticised film based on polyvinyl acetal contains 0.001 to 5 % by weight of SiO₂.

6. The photovoltaic module according to one of Claims 1 to 5, **characterised in that** the photosensitive semiconductor layers are applied to the cover d) and are glued to the transparent front cover a) by at least one plasticised film based on polyvinyl acetal c).

7. The photovoltaic module according to one of Claims 1 to 5, **characterised in that** the photosensitive semiconductor layers are applied to the transparent front cover a) and are glued to the rear cover d) by at least one plasticised film based on polyvinyl acetal c).

8. The photovoltaic module according to one of Claims 1 to 5, **characterised in that** one or more photosensitive semiconductor layers b) are embedded between two films c) and are glued to the covers a) and d).

9. Use of plasticised films based on polyvinyl acetal, which, in an ambient climate of 85 % RH/23 °C, have an electrical volume resistivity of more than 1E12 ohm*cm, and a glass transition temperature Tg of less than 20 °C and an alkali titre above 5 and comprise polyvinyl acetal with a polyvinyl alcohol proportion of less than 18 % by weight, for the production of photovoltaic modules.

10. The use of photovoltaic modules according to one of Claims 1 to 8 as a facade component, roof panes, winter garden covering, soundproofing wall, balcony or railing element, or as a component of window areas.

## Revendications

1. Module photovoltaïque, comprenant un stratifié en
a) une couverture frontale transparente
b) une ou plusieurs couches semi-conductrices photosensibles
c) au moins une feuille à base de polyvinylacétale contenant des plastifiants, laquelle présente dans un climat ambiant de 85% r.F./23°C une résistance de passage électrique spécifique de plus de 1E12 ohms*cm et
d) une couverture arrière
**caractérisé en ce que** la feuille c) à base de polyvinylacétale contenant des plastifiants présente une température de transition vitreuse Tg de moins de 20°C et un titre alcalin supérieur à 5 et **en ce que** le polyvinylacétale présente une part d'alcool polyvinylique de moins de 18% en poids.

2. Module photovoltaïque selon la revendication 1, **caractérisé en ce que** les feuilles c) à base de polyvinylacétale contenant des plastifiants présentent une teneur en plastifiants d'un maximum de 40% en poids.

3. Module photovoltaïque selon l'une des revendications 1 à 2, **caractérisé en ce que** le polyvinylacétale présente une teneur en acétate de polyvinyle de moins de 3% en poids.

4. Module photovoltaïque selon l'une des revendications 1 à 3, **caractérisé en ce que** les feuilles c) à base de polyvinylacétale contenant des plastifiants contiennent un sel métallique d'un acide carboxylique avec 1 à 15 atomes de carbone en tant que composé basique.

5. Module photovoltaïque selon l'une des revendications 1 à 4, **caractérisé en ce que** la feuille à base de polyvinylacétale contenant des plastifiants contient 0,001 à 5 % en poids de SiO₂.

6. Module photovoltaïque selon l'une des revendications 1 à 5, **caractérisé en ce que** les couches semi-conductrices photosensibles sont appliquées sur la couverture d) et sont collées ensemble avec la couverture frontale a) transparente grâce à au moins une feuille c) à base de polyvinylacétale contenant des plastifiants.

7. Module photovoltaïque selon l'une des revendications 1 à 5, **caractérisé en ce que** les couches semi-conductrices photosensibles sont appliquées sur la couverture frontale a) transparente et sont collées ensemble avec la couverture arrière d) grâce à au moins une feuille c) à base de polyvinylacétale contenant des plastifiants.

8. Module photovoltaïque selon l'une des revendications 1 à 5, **caractérisé en ce qu'**une ou plusieurs couches semi-conductrices photosensibles b) sont noyées entre deux feuilles c) et collées ensemble avec les couvertures a) et d).

9. Utilisation de feuilles à base de polyvinylacétale contenant des plastifiants, lesquelles présentent dans un climat ambiant de 85% r.F./23°C une résistance de passage électrique spécifique de plus de 1E12 ohms*cm et une température de transition vitreuse Tg de moins de 20°C et un titre alcalin supérieur à 5 et du polyvinylacétale avec une part d'alcool polyvinylique de moins de 18% en poids, pour la fabrication de modules photovoltaïques.

10. Utilisation de modules photovoltaïques selon l'une des revendications 1 à 8 en tant qu'élément de façade, surface de toiture, couverture de jardin d'hiver, mur antibruit, élément de balcon ou de parapet ou en tant qu'élément constitutif de surfaces de fenêtres.
